Europäisches Patentamt

European Patent Office

Office européen des brevets

(11) Numéro de publication : **0 061 403**
**B1**

# (12) FASCICULE DE BREVET EUROPÉEN

(45) Date de publication du fascicule du brevet :
**20.02.85**

(21) Numéro de dépôt : **82400507.8**

(22) Date de dépôt : **19.03.82**

(51) Int. Cl.⁴ : **H 03 F 1/30, G 01 S 7/28,**
**G 01 S 7/36, H 01 Q 21/29**

(54) **Dispositif de compensation des dérivés d'au moins une chaîne de mesure et son application.**

(30) Priorité : **24.03.81 FR 8105857**

(43) Date de publication de la demande :
**29.09.82 Bulletin 82/39**

(45) Mention de la délivrance du brevet :
**20.02.85 Bulletin 85/08**

(84) Etats contractants désignés :
**DE GB IT NL**

(56) Documents cités :
**FR-A- 2 289 018**
**FR-A- 2 357 905**
**US-A- 4 010 469**
**US-A- 4 078 156**
**TOUTE L'ELECTRONIQUE, no. 459, décembre 1980**
**PARIS (FR) G. MOURIER: "Amplification à très faible**
**dérive: "chopper" ou bipolaires hautes performan-**
**ces" pages 61-65**

(73) Titulaire : **THOMSON-CSF**
**173, Boulevard Haussmann**
**F-75379 Paris Cedex 08 (FR)**

(72) Inventeur : **Morvan, Jean-Georges**
**THOMSON-CSF SCPI 173, bld Haussmann**
**F-75360 Paris Cedex 08 (FR)**

(74) Mandataire : **Jacquard, Philippe et al**
**THOMSON-CSF SCPI 173, Bld Haussmann**
**F-75379 Paris Cedex 08 (FR)**

EP 0 061 403 B1

## Description

La présente invention a pour objet un dispositif de compensation des dérives d'au moins une chaîne de mesure et son application à un dispositif de compensation des lobes secondaires d'un radar secondaire.

La compensation des dérives des amplificateurs utilisés pour amplifier des signaux impulsionnels est réalisée dans l'art antérieur en prenant en compte uniquement les dérives du zéro de l'amplificateur en fonction de la stabilité de la tension d'alimentation, de la température du milieu ambiant, du temps, etc. La compensation est alors réalisée par simple translation de la caractéristique entrée-sortie de l'amplificateur. Un tel dispositif est décrit par exemple dans le brevet américain N° 4 078 156.

Ce type de compensation est inadapté au cas où la dérive se traduit non pas par une translation simple, mais par une déformation de la caractéristique qui a pour effet d'entraîner par exemple une variation de niveau continu différente pour un signal faible et pour un signal fort. Un amplificateur logarithmique notamment produit une variation de niveau continu plus forte pour un signal faible que pour un signal fort.

L'invention a ainsi pour objet un dispositif permettant de compenser les dérives des amplificateurs disposés dans les chaînes de mesure, quelle que soit la forme sous laquelle ces dérives se manifestent.

Un dispositif de compensation des dérives d'une chaîne de mesure selon l'invention comporte un circuit appliquant à ladite chaîne de mesure soit un signal d'entrée de mesure, soit un signal d'entrée de référence différent de zéro, auxquels correspondent respectivement un signal de sortie de mesure, et un signal de sortie de référence, une mémoire mémorisant la valeur dudit signal de sortie de référence, et un circuit soustracteur soustrayant du signal de sortie de mesure ladite valeur mémorisée.

L'invention concerne également un dispositif de compensation des dérives de deux chaînes de mesure montées en différentiel, lequel comporte un circuit appliquant à chacune des chaînes de mesure un signal d'entrée de mesure, et un signal d'entrée de référence auxquels correspondent respectivement pour chaque chaîne un signal de sortie de mesure, et un signal de sortie de référence, un circuit mémorisant la valeur du signal de sortie de référence respectivement pour une chaîne et pour l'autre, et un circuit soustracteur soustrayant respectivement de chacun des signaux de sortie de mesure la valeur mémorisée correspondante, et réalisant également la soustraction entre eux des résultats des deux soustractions précédentes.

L'invention concerne enfin un dispositif de compensation des dérives de deux chaînes de mesure montées en différentiel, lequel comporte un circuit appliquant à chaque chaîne de mesure un signal d'entrée de mesure, et un signal d'entrée de référence, auxquels correspondent respectivement pour chaque chaîne un signal de sortie de mesure, et un signal de sortie de référence, un circuit mémorisant la différence des valeurs des signaux de sortie de référence respectivement pour une chaîne et pour l'autre, et un circuit soustracteur réalisant la soustraction des signaux de mesure de chacune des chaînes de mesure et leur soustrayant ladite différence mémorisée.

Un dispositif selon l'invention peut être avantageusement appliqué à un dispositif de compensation des lobes secondaires d'un radar secondaire pour lequel un signal de mesure est le signal d'un premier récepteur associé au radar secondaire et l'autre signal de mesure est le signal d'un second récepteur associé au radar secondaire.

L'invention sera mieux comprise dans la description qui va suivre donnée à titre d'exemple non limitatif en se reportant aux dessins ci-annexés et où :

les figures $1_a$ et $1_b$ illustrent un dispositif de compensation des dérives d'une chaîne de mesure selon l'invention ;

les figures 2 à 4 représentent des modes de réalisation d'un dispositif de compensation des dérives de deux chaînes de mesure suivant l'invention ;

la figure $5_a$ représente les diagrammes de directivité d'un premier et d'un second récepteur associés à un radar secondaire, l'un directif, l'autre non directif ;

la figure $5_b$ illustre un mode de réalisation permettant de faire varier l'arc d'interrogation ;

la figure 6 représente un mode de réalisation de l'invention adapté à la compensation des lobes secondaires de l'antenne d'un radar secondaire ;

la figure 7 représente un mode de répartition temporelle des signaux de mesure et de référence dans le cas d'un radar ;

la figure 8 illustre un mode de commutation réalisée au niveau d'une antenne ;

les figures $9_a$ et $9_b$ représentent des courbes illustrant la fonction anti-brouillage d'un dispositif selon l'invention ;

la figure 10 représente une variante de l'invention où une chaîne de mesure est en outre recalée par rapport à une chaîne de référence.

La figure $1_a$ représente un dispositif de compensation, où un dispositif 2 qui peut être un dispositif de commutation introduit dans une chaîne de mesure 3 un signal provenant d'un détecteur 1, et/ou un signal de référence produit par un circuit 1'. Le circuit 2 est commandé par une ligne 8 qui commande également la commutation d'une mémoire 4 entre une position d'écriture lorsque la chaîne 3 reçoit un signal de référence, et une position de lecture lorsque la chaîne 3 reçoit un signal de mesure. Le signal de mesure $s_{1m}$, et le signal de référence $s_{1r}$ présent à la sortie de la mémoire 4, sont introduits aux deux entrées d'un amplificateur opérationnel 5 monté en soustracteur. L'amplificateur 5 comporte une résistance de contre-réaction $R_6$ et

deux résistances d'entrée $R_6$ respectivement à ses bornes d'entrée inverseuse et non inverseuse, ainsi qu'une résistance $R_6$ entre son entrée non inverseuse et la masse. Ainsi, le signal de sortie $S_1$ de l'amplificateur 5 est la différence entre le signal de mesure et le signal de référence mémorisés. En choisissant le signal de référence de manière à ce qu'il se trouve dans la partie utile de la dynamique de la chaîne de mesure, la dérive est compensée au niveau de la partie utile de sa caractéristique et non point seulement au niveau d'une dérive de zéro. Cette situation est représentée à la figure $1_b$ qui porte en ordonnée la sortie s de la chaîne de mesure de laquelle a été retranchée la valeur du signal $s_{1r}$ de référence mis en mémoire. Quelle que soit la dérive de la caractéristique de la chaîne de mesure au moment où le signal de référence lui est appliqué, l'ensemble des caractéristiques de celle-ci concourent en un point d'ordonnée nulle et d'abscisse $G_r$, $G_r$ étant la grandeur de référence appliquée à l'entrée de la chaîne de mesure. Il en résulte que la compensation est parfaitement réalisée au niveau de la valeur de référence, et approximativement autour de cette valeur, l'approximation étant toutefois du second ordre, c'est-à-dire négligeable en pratique.

Le circuit 2 peut être commandé par la ligne 8 à des intervalles réguliers de manière à tenir compte de l'évolution de la dérive.

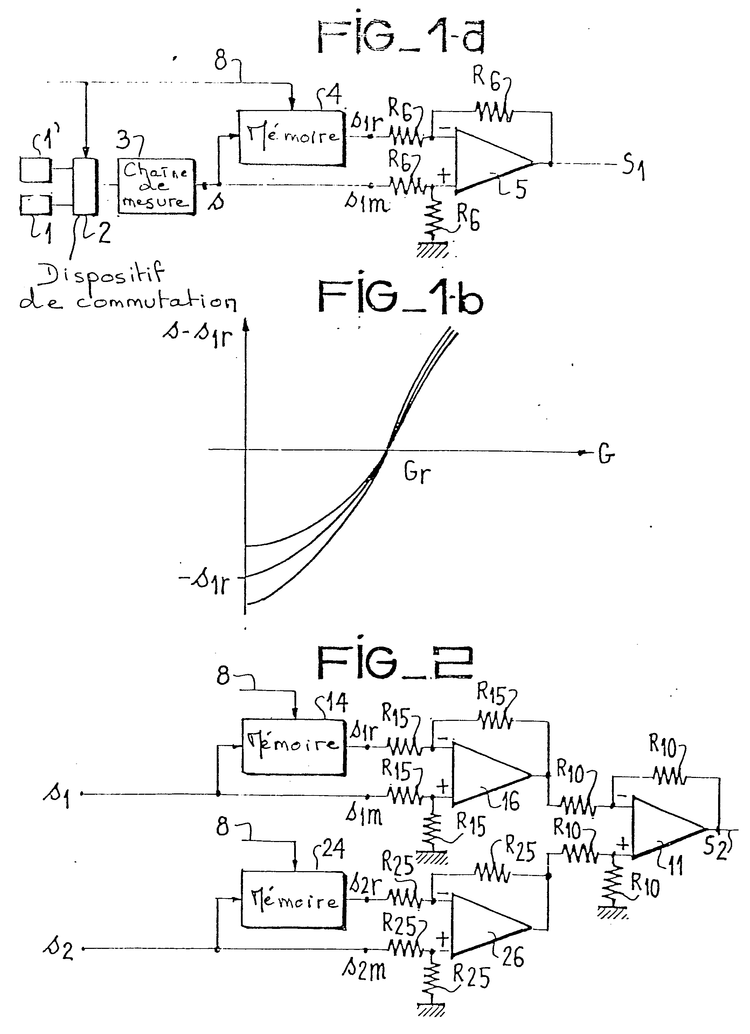

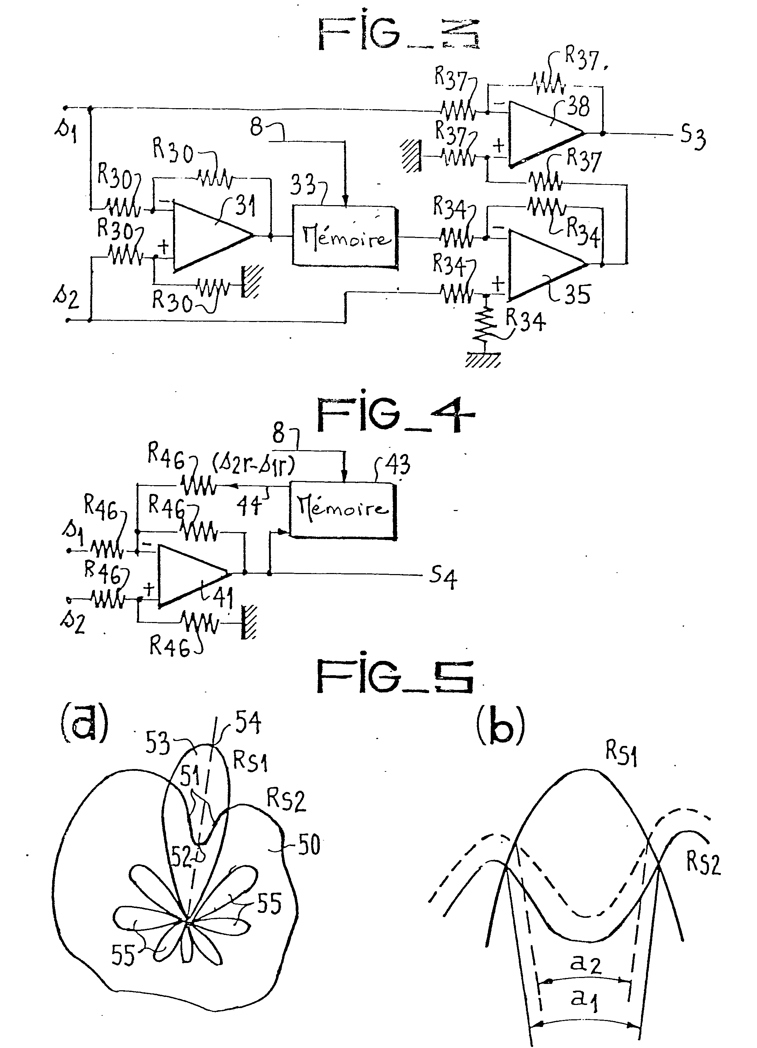

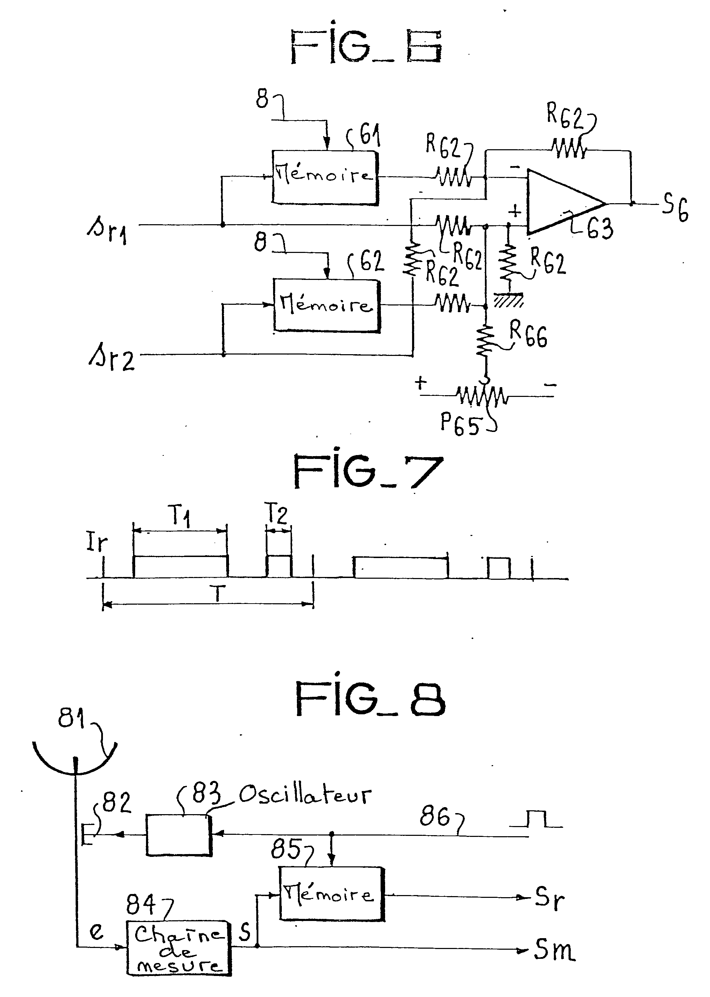

La figure 2 représente un dispositif de compensation des dérives de deux chaînes de mesure différentielles qui délivrent chacune des signaux de sortie respectivement $S_1$ et $S_2$. Ces signaux sont introduits à l'entrée positive de deux amplificateurs différentiels respectivement 16 et 26. Les valeurs mémorisées dans des mémoires respectivement 14 et 24 et correspondant à des signaux de sortie de référence, sont introduits à l'entrée négative des amplificateurs différentiels 16 et 26. L'amplificateur 16 est pourvu d'une résistance de contre-réaction $R_{15}$ et de deux résistances d'entrée $R_{15}$ disposées respectivement à l'entrée inverseuse et non inverseuse, ainsi que d'une résistance $R_{15}$ disposée entre son entrée non inverseuse et la masse. L'amplificateur 26, de la même façon, est pourvu d'une résistance de contre-réaction $R_{25}$ et de deux résistances d'entrée $R_{25}$ disposées respectivement à l'entrée inverseuse et non inverseuse, ainsi que d'une résistance $R_{25}$ disposée entre son entrée non inverseuse et la masse. Les signaux de sortie des amplificateurs 16 et 26 sont introduits respectivement à l'entrée négative et positive d'un amplificateur différentiel 11 pourvu d'une résistance de contre-réaction $R_{10}$ et de deux résistances d'entrée $R_{10}$ disposées à son entrée inverseuse et à son entrée non inverseuse, ainsi que d'une résistance $R_{10}$ disposée entre son entrée non inverseuse et la masse. Les gains des amplificateurs 11, 16 et 26 au niveau de leurs différentes entrées peuvent bien entendu être choisis différents de 1, pourvu que les grandeurs mesurées identiques sur chacune des deux chaînes de mesure correspondent à des valeurs identiques à la sortie de l'amplificateur 11. Dans ces conditions, la sortie $S_2$ correspondra, à un facteur multiplicatif près, à la différence :

$$S_{2m} - s_{1m} - (s_{2r} - s_{1r}).$$

On a ainsi réalisé une compensation au niveau d'une chaîne de mesure différentielle.

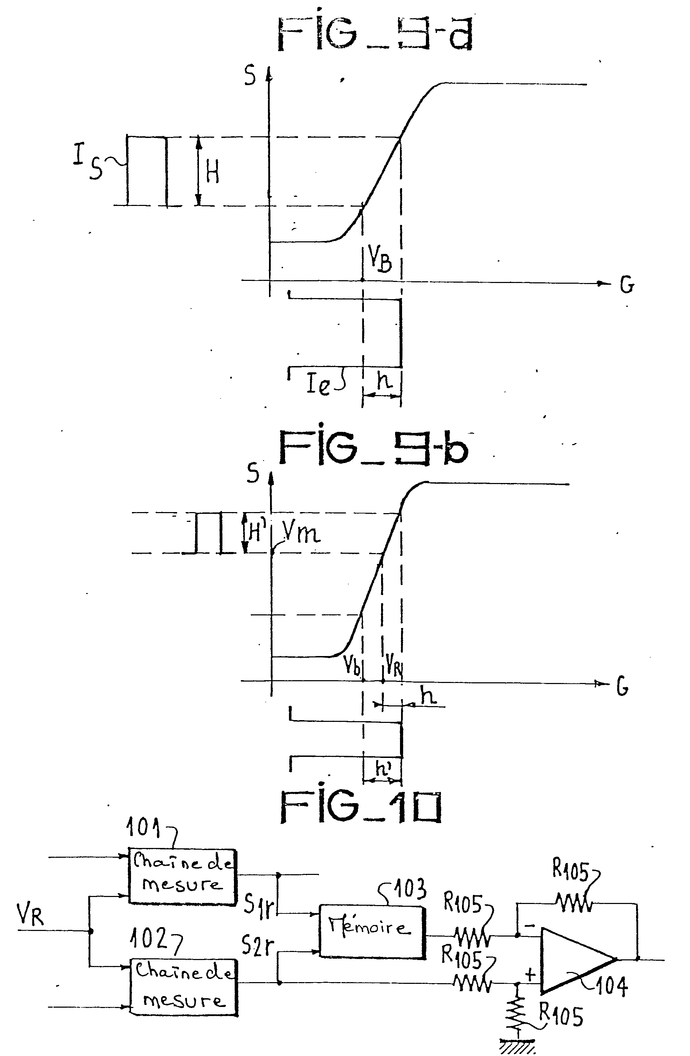

La figure 3 représente une variante de la figure 2 où la différence des signaux de sortie de référence est mémorisée dans une mémoire 33, par exemple en utilisant un amplificateur différentiel 31 recevant à chacune de ses entrées les signaux de sortie des deux chaînes de mesure, cet amplificateur étant pourvu d'une résistance de contre-réaction $R_{30}$ et de deux résistances d'entrée de valeur également égale à $R_{30}$. La sortie de la mémoire 33 est introduite à l'entrée négative d'un amplificateur différentiel 35 qui reçoit à son autre entrée le signal de sortie de mesure $s_{2m}$. Cet amplificateur est pourvu d'une résistance de contre-réaction $R_{34}$ et de deux résistances d'entrée $R_{34}$ ainsi que d'une résistance $R_{34}$ entre son entrée non inverseuse et la masse. La sortie d'un amplificateur 35 est introduite à l'entrée positive d'un amplificateur différentiel 38 qui reçoit à son entrée négative le signal de mesure $s_{1m}$ de la première chaîne de mesure. L'amplificateur 38 est pourvu d'une résistance de contre-réaction $R_{37}$, de deux résistances d'entrée $R_{37}$ et d'une résistance $R_{37}$ entre son entrée non inverseuse et la masse. Les gains d'ensemble étant, comme dans le cas précédent, équilibrés, la sortie $S_3$ de l'amplificateur différentiel 38 correspond à la sortie $S_2$ de la figure 2.

La figure 4 représente également une variante relative à la compensation de deux chaînes de mesure différentielles. Les signaux $S_1$ et $S_2$ de sortie des deux chaînes de mesure sont introduits respectivement à l'entrée négative et positive d'un amplificateur différentiel 41 pourvu d'une résistance de contre-réaction $R_{46}$ et de deux résistances d'entrée $R_{46}$ ainsi que d'une résistance $R_{46}$ entre son entrée non inverseuse et la masse. La sortie de l'amplificateur 41 est introduite dans une mémoire 43 par une ligne 42, et la sortie 44 correspondant à la lecture de la mémoire est introduite à l'entrée négative de l'amplificateur 41, également à travers une résistance d'entre $R_{46}$. Dans ces conditions, le signal $S_4$ correspond aux signaux de sortie $S_2$ et $S_3$ des figures 2 et 3.

La figure $5_a$ représente les diagrammes angulaires correspondant à des antennes à diagrammes multiples dont les formes sont définies de façon à pouvoir mieux délimiter l'arc d'interrogation et à discréminer les réponses provenant d'un lobe principal et celles provenant des lobes secondaires. Le diagramme RS1 présente un lobe principal 53 pourvu d'un maximum 54 qui correspond à l'axe géométrique de l'antenne, et une pluralité de lobes secondaires 55 d'amplitude plus faible. Le diagramme RS2 se présente sous la forme générale d'une cardioïde et présente un gain minimum en 52 dans la direction principale constituant l'axe géométrique de l'antenne. Au niveau des lobes secondaires, le diagramme RS2 correspond à une amplitude supérieure à celle de tous les lobes secondaires 55. En comparant les amplitudes respectives des signaux de sortie des deux récepteurs correspondant à RS1 et RS2 et en ne conservant que les signaux RS1 supérieurs aux signaux RS2, il est possible de distinguer les signaux provenant du lobe principal 53 et ceux provenant des lobes secondaires 55. Cette technique est connue sous le nom de RSLS (suppression des lobes secondaires à la réception). Le résultat de la comparaison, pour être correct, exige que les récepteurs soient insensibles aux variations de paramètres extérieurs tels que température, tension d'alimentation, fréquences porteuses si le récepteur est à large bande, etc.

La figure $5_b$ illustre la variation de l'arc d'interrogation qui peut être obtenue en ajoutant une constante au diagramme RS2 : l'arc d'interrogation $a_2$ situé plus près du sommet de RS1 est ainsi plus étroit que l'arc d'interrogation $a_1$, ce qui permet une interrogation plus fine.

La figure 6 illustre l'application d'un dispositif selon l'invention à la compensation des chaînes de mesure d'un système RSLS. Ainsi qu'il a été dit plus haut, la compensation aura lieu en effectuant de façon périodique, en dehors du temps d'utilisation normale du récepteur, la mise en mémoire de l'amplitude de la réponse associée à un signal d'amplitude connu pour chacun des récepteurs. La réponse du récepteur à un signal d'entrée d'amplitude quelconque sera comparée à la réponse mémorisée afin de ne prendre en compte que la différence entre ces deux signaux.

La figure 6 représente ainsi un dispositif correspondant à un schéma équivalent aux figures 2 à 4, où les valeurs de mesure présentes en sortie des deux chaînes $s_{r1}$ et $s_{r2}$ sont appliquées respectivement à l'entrée positive et négative d'un amplificateur différentiel 63 pourvu d'une résistance de contre-réaction $R_{62}$, à travers des résistances d'entrée $R_{62}$, et où les valeurs mémorisées respectivement par les mémoires 61 et 62 présentes en sorties desdites chaînes de mesure, sont appliquées respectivement aux entrées négatives et positives de l'amplificateur différentiel 63 à travers des résistances d'entrée $R_{62}$. Le signal compensé $S_6$ présent en sortie de l'amplificateur 63 aura un signe positif pour les signaux correspondant aux lobes principaux 53 du diagramme RS1. D'autre part, afin de faciliter la discrimination, on introduit à l'entrée de l'amplificateur 63 un signal de seuil par l'intermédiaire d'un potentiomètre $P_{65}$ dont les deux bornes fixes sont reliées aux bornes positives et négatives d'un générateur de tension continu et dont le curseur est relié par exemple à l'entrée + de l'amplificateur 63 à travers une résistance $R_{66}$. Ceci permet de déplacer le diagramme RS2 comme indiqué à la figure $5_b$.

La figure 7 illustre un mode de répartition temporelle entre les signaux de mesure et les signaux de référence dans le cas de la technique radar. Les impulsions radar récurrentes $I_r$ sont

séparées par des intervalles de temps T. La mesure a lieu pendant l'intervalle de temps $T_1$, et le signal de référence est produit pendant l'intervalle de temps $T_2$ à un instant différent de $T_1$ et de préférence après $T_1$ (par exemple : $T_1 = 1$ ms, $T_2 = $ qq $\mu$s). Il est également possible de produire le signal de référence pendant un temps $T_2$ situé dans l'intervalle de temps $T_1$, puisque $T_2$ est très petit devant $T_1$, et que la probabilité de recevoir un écho radar pendant l'intervalle de temps $T_2$ est faible.

La figure 8 illustre la commutation réalisée au niveau d'une antenne 81. Une impulsion de synchronisation amenée par une ligne 86 commande simultanément un oscillateur 83 couplé à la sortie de l'antenne 81 par un coupleur 82, et l'écriture dans une mémoire 85. Il en résultera une impulsion de référence appliquée à l'entrée de la chaîne de mesure 84 tant que l'impulsion de synchronisation est présente. La valeur $S_r$ mémorisée reste présente en permanence à la sortie de la mémoire M.

Un tel dispositif est particulièrement avantageux dans le cas de la technique considérée car il constitue non seulement une compensation des dérives de la chaîne de réception mais également une compensation du brouillage que l'antenne radar est susceptible de détecter. En effet, un brouillage se traduit en général par la présence à la sortie de l'antenne d'une tension continue qui se superpose au signal.

Selon la figure $9_a$ qui correspond à l'art antérieur, une impulsion présente à la sortie de l'antenne et dépassant d'une quantité h du niveau continu de brouillage $V_B$ donnera lieu en sortie à une impulsion de hauteur H dont le niveau est fonction du niveau continu de brouillage $V_B$.

Selon la figure $9_b$ qui correspond à une mise en œuvre de l'invention, une impulsion présente à la sortie de l'antenne et dépassant d'une quantité h du niveau de référence $V_R$ et d'une quantité h' du niveau continu de brouillage $V_B$ donnera lieu en sortie à une impulsion de hauteur H' dont la hauteur est fonction de $V_R$ tant que $V_R$ reste supérieur à $V_B$.

Lorsque le niveau de brouillage augmente pour se rapprocher de $V_R$, la valeur mémorisée $V_M$ correspondant à la sortie de l'une ou l'autre chaîne de mesure dérive progressivement. Il est alors possible d'identifier la présence d'un brouillage plus ou moins intense en fixant un ou plusieurs seuils de dérive, soit en niveau, soit en pente, pour la valeur mémorisée $V_M$. Pour ce faire, on introduit au moins un signal mémorisé $V_M$ dans un circuit comportant au moins un seuil. Un tel contrôle permet également de vérifier le bon état de fonctionnement de la chaîne de mesure.

La figure 10 illustre une variante de l'invention où une chaîne de mesure 101 est d'une qualité telle qu'elle ne présente pas de dérive. Cette chaîne de référence fonctionne avec au moins une autre chaîne de mesure 102 qui, de qualité et de coût moindre, présente des dérives qu'il s'agit de compenser. Les valeurs $S_{1r}$ et $S_{2r}$ correspon-

dant à un signal de référence identique $V_r$ appliqué aux deux chaînes sont introduites dans une mémoire 103 qui mémorise leur différence ($S_{2r} - S_{1r}$). La sortie de la mémoire 103 et de la chaîne de mesure 102 sont introduites dans un amplificateur différentiel 104 de manière à produire à sa sortie un signal $S_{2m} - (S_{2r} - S_{1r})$. Les chaînes de mesure telles que 102 sont alors continuellement recalées par rapport à la chaîne de référence 101.

## Revendications

1. Dispositif de compensation des dérives d'au moins une chaîne de mesure, caractérisé en ce qu'il comporte :

— un circuit (2) appliquant à ladite chaîne de mesure soit un signal d'entrée de mesure, soit un signal d'entrée de référence différent de zéro, auxquels correspondent respectivement un signal de sortie de mesure ($S_{1m}$), et un signal de sortie de référence ($S_{1r}$),

— une mémoire (4) mémorisant la valeur dudit signal de sortie de référence,

— un circuit soustracteur (5) soustrayant du signal de sortie de mesure, ladite valeur mémorisée.

2. Dispositif selon la revendication 1, caractérisé en ce que le circuit (2) est actionné à intervalles réguliers par un circuit de commande (8) de telle sorte que des valeurs de référence sont mises en mémoire à des intervalles réguliers.

3. Dispositif selon l'une des revendications 1 ou 2, caractérisé en ce qu'il comporte une chaîne de mesure de référence (101) et au moins une chaîne de mesure à compenser (102) et en ce qu'il comprend un circuit (103, 104) ajoutant à chaque sortie de mesure de chaque chaîne à compenser un signal mémorisé correspondant à la différence des sorties de la chaîne de référence et de la chaîne à compenser quand on applique à leur entrée le signal de référence ($V_r$).

4. Dispositif de compensation des dérives de deux chaînes de mesure montées en différentiel caractérisé en ce qu'il comporte :

— un circuit appliquant à chacune des chaînes de mesure soit un signal d'entrée de mesure, soit un signal d'entrée de référence différent de zéro, auxquels correspondent respectivement pour chaque chaîne un signal de sortie de mesure ($S_{1m}$, $S_{2m}$), et un signal de sortie de référence ($S_{1r}$, $S_{2r}$),

— un circuit (14, 24) mémorisant la valeur du signal de sortie de référence ($S_{1r}$, $S_{2r}$) respectivement pour une chaîne et pour l'autre,

— un circuit soustracteur (16, 26, 11) soustrayant respectivement de chacun des signaux de sortie de mesure la valeur mémorisée correspondante, et réalisant également la soustraction entre eux des résultats des deux soustractions précédentes.

5. Dispositif de compensation des dérives de deux chaînes de mesure montées en différentiel caractérisé en ce qu'il comporte :

— un circuit appliquant à chaque chaîne de mesure soit un signal d'entrée de mesure, soit un signal d'entrée de référence différent de zéro, auxquels correspondent respectivement pour chaque chaîne un signal de sortie de mesure ($S_{1m}$, $S_{2m}$), et un signal de sortie de référence ($S_{1r}$, $S_{2r}$),

— un circuit (33, 43) mémorisant la différence des valeurs des signaux de sortie de référence respectivement pour une chaîne et pour l'autre, calculée par un circuit de soustraction (31, 41),

— un circuit soustracteur (35 et 38, 41) réalisant la soustraction des signaux de mesure de chacune des chaînes de mesure et leur soustrayant ladite différence mémorisée.

6. Dispositif selon l'une des revendications 4 ou 5, caractérisé en ce que le signal d'entrée de référence est le même pour les deux chaînes.

7. Dispositif selon l'une des revendications 3 à 6, caractérisé en ce que ledit circuit appliquant à chaque chaîne de mesure un signal d'entrée de mesure et un signal d'entrée de référence, applique ledit signal d'entrée de référence à des intervalles réguliers.

8. Application d'un dispositif selon l'une des revendications 4 à 7 à un dispositif de compensation des lobes secondaires d'un radar secondaire, caractérisé en ce qu'un signal de mesure est le signal d'un premier récepteur associé au radar secondaire et que l'autre signal de mesure est le signal d'un second récepteur associé au radar secondaire.

9. Application selon la revendication 8, caractérisée en ce que le circuit soustracteur comporte un circuit lui appliquant un signal continu additionnel ce qui permet de faire varier l'arc d'interrogation.

10. Application selon l'une des revendications 8 ou 9, caractérisée en ce qu'il comprend un circuit pour produire des signaux de référence pendant l'intervalle de temps compris entre le temps d'interrogation ($T_1$) et l'impulsion radar récurrente suivante $I_r$.

11. Application selon l'une des revendications 8 à 10, caractérisée en ce qu'au moins un signal mémorisé ($V_M$) est introduit dans un circuit comportant au moins un seuil.

## Claims

1. Device for compensating the deviations of at least one measuring chain, characterized in that it comprises :

— a circuit (2) applying to each measuring chain either a measurement input signal or a reference input signal different from zero, to which signals corresponds respectively a measurement output signal ($S_{1m}$) and a reference output signal ($S_{1r}$) ;

— a memory (4) for memorizing the value of said reference output signal ;

— a subtracting circuit (5) for subtracting said memorized value from the measurement output signal.

2. Device according to claim 1, characterized in that the circuit (2) is actuated at regular intervals by a control circuit (8) in such a manner that the reference values are memorized at regular intervals.

3. Device according to one of claims 1 or 2, characterized in that it comprises a reference measuring chain (101) and at least one measuring chain to be compensated (102), and in that it comprises a circuit (103, 104) for adding to each measurement output of each chain to be compensated a memorized signal corresponding to the difference between the outputs of the reference chain and the chain to be compensated, when the reference signal ($V_r$) is applied to the input thereof.

4. Device for compensating the deviations of two measuring chains mounted in accordance with a differential circuit arrangement, characterized in that it comprises :
— a circuit for applying to each one of said measuring chains either a measurement input signal or a reference input signal different from zero, to which signals corresponds respectively, for each chain, a measurement output signal ($S_{1m}$, $S_{2m}$) and a reference output signal ($S_{1r}$, $S_{2r}$) ;
— a circuit (14, 24) for memorizing the value of the reference output signal ($S_{1r}$, $S_{2r}$) for one chain and for the other, respectively ;
— a subtracting circuit (16, 26, 11) for subtracting respectively from each measurement output signal the corresponding memorized value, and for performing also the subtraction between the results of the two preceding subtractions.

5. Device for compensating the deviations of two measuring chains mounted in accordance with a differential circuit arrangement, characterized in that it comprises :
— a circuit for applying to each measuring chain either a measurement input signal or a reference input signal different from zero, to which signals correspond respectively, for each chain, a measurement output signal ($S_{1m}$, $S_{2m}$) and a reference output signal ($S_{1r}$, $S_{2r}$) ;
— a circuit (33, 34) for memorizing, for one chain and for the other, respectively, the difference between the values of the reference output signals, as calculated by a subtracting circuit (31, 41) ;
— a subtracting circuit (35 and 38, 41) for performing the subtraction of the measurement signals of each one of said chains, and for subtracting therefrom said memorized difference.

6. Device according to one of claims 4 or 5, characterized in that the reference input signal is identical for both chains.

7. Device according to one of claims 3 to 6, characterized in that the said circuit for applying to each measuring chain a measurement input signal and a reference input signal applies said reference input signal at regular intervals.

8. Application of a device according to one of claims 4 to 7 to a device for compensating the side lobes of a secondary radar, characterized in that one measurement signal is the signal of a first receiver associated to the secondary radar, and in that the other measurement signal is the signal of a second receiver associated to the secondary radar.

9. Application according to claim 8, characterized in that the subtracting circuit comprises a circuit for applying thereto a continuous additional signal, whereby it is possible to vary the interrogation arc.

10. Application according to one of claims 8 or 9, characterized in that a circuit is provided for generating reference signals during the time interval comprised between the interrogation time ($T_1$) and the subsequent recurrent radar pulse ($I_r$).

11. Application according to one of claims 8 to 10, characterized in that at least one memorized signal ($V_M$) is introduced into a circuit comprising at least one threshold.

**Ansprüche**

1. Vorrichtung zur Ausgleichung der Abweichungen wenigstens einer Messkette, dadurch gekennzeichnet, dass sie umfasst :
— einen an die Messkette entweder ein Eingangsmessignal oder ein von Null verschiedenes Eingangsbezugssignal anlegenden Stromkreis (2) welchen Signalen jeweils ein Ausgangsmessignal ($S_{1m}$) bzw. ein Ausgangsbezugssignal ($S_{1r}$) entspricht ;
— einen den Wert des Ausgangsbezugssignals speichernden Speicher (4) ;
— einen den gespeicherten Wert vom Ausgangsmessignal subtrahierenden Subtraktionsstromkreis (5).

2. Vorrichtung nach Anspruch 1, dadurch gekennzeichnet, dass der Stromkreis (2) durch einen Steuerstromkreis (8) in regelmässigen Zeitabständen derart bestätigt wird, dass die Bezugswerte in regelmässigen Zeitabständen gespeichert werden.

3. Vorrichtung nach einem der Ansprüche 1 oder 2, dadurch gekennzeichnet, dass sie eine Bezugsmesskette (101) und wenigstens eine auszugleichende Messkette (102) umfasst, und dass sie einen Stromkreis (103, 104) aufweist, der jedem Mess-Ausgang jeder auszugleichenden Kette ein gespeichertes Signal beifügt, das der Differenz zwischen den Ausgänge der Bezugskette und der auszugleichenden Kette entspricht, wenn an ihren Eingang das Bezugssignal ($V_r$) angelegt wird.

4. Vorrichtung zur Ausgleichung der Abweichungen zweier in Differentialschaltung angeordneter Messketten, dadurch gekennzeichnet, dass sie umfasst :
— einen an jeden der Messketten entweder ein Eingangsmessignal oder ein von Null verschiedenes Eingangsbezugssignal anlegenden Stromkreis, welchen Signalen für die jeweilige Kette ein Ausgangsmessignal ($S_{1m}$, $S_{2m}$) bzw. ein Ausgangsbezugssignal ($S_{1r}$, $S_{2r}$) entspricht ;

— einen den Wert des Ausgangsbezugssignals ($S_{1r}$, $S_{2r}$) für die eine bzw. die andere Kette speichernden Stromkreis (14, 24) ;

— einen jeweils von jedem der Ausgangsmessignale den entsprechenden gespeicherten Wert subtrahierend Subtraktionsstromkreis (16, 26, 11), der auch die Subtraktion zwischen den beiden vorhergehenden Subtraktionen durchführt.

5. Vorrichtung zur Ausgleichung der Abweichungen zweier in Differentialschaltung angeordneter Messketten, dadurch gekennzeichnet, dass sie umfasst :

— einen an jede Messkette entweder ein Eingangsmessignal oder ein von Null verschiedenes Eingangsbezugssignal anlegenden Stromkreis, welchen Signalen für die jeweiligen Kette ein Ausgangsmessignal ($S_{1m}$, $S_{2m}$) bzw. ein Ausgangsbezugssignal ($S_{1r}$, $S_{2r}$) entspricht ;

— einen jeweils für die eine und die andere Kette die durch einen Subtraktionsstromkreis (31, 41) berechnete Differenz zwischen den Werten der Ausgangsbezugssignale speichernden Stromkreis (33, 34) ;

— einen die Subtraktion der Messignale jeder Messkette durchführenden und die gespeicherte Differenz von denselben subtrahierenden Subtraktionsstromkreis (35 und 38, 41).

6. Vorrichtung nach einem der Ansprüche 4 oder 5, dadurch gekennzeichnet, dass das Eingangsbezugssignal für die beiden Ketten jeweils das gleiche ist.

7. Vorrichtung nach einem der Ansprüche 3 bis 6, dadurch gekennzeichnet, dass der an jede Messkette eine Eingangsmessignal und ein Eingangsbezugssignal anlegende Stromkreis dieses Eingangsbezugssignal in regelmässigen Zeitabständen anlegt.

8. Anwendung einer Vorrichtung nach einem der Ansprüche 4 bis 7 bei einer Vorrichtung zur Ausgleichung der Nebenkeulen eines Sekundärradars, dadurch gekennzeichnet, dass ein Messignal das Signal eines mit dem Sekundärradar zusammenwirkenden ersten Empfängers ist, und dass das andere Messignal das Signal eines mit dem Sekundärradar zusammenwirkenden zweiten Empfängers ist.

9. Anwendung nach Anspruch 8, dadurch gekennzeichnet, dass der Subtraktionsstromkreis einen an denselben ein ununterbrochenes zusätzliches Signal anlegenden Stromkreis aufweist, wodurch es ermöglicht wird, den Impulsausstrahlungsbogen zu verändern.

10. Anwendung nach einem der Ansprüche 8 oder 9, dadurch gekennzeichnet, dass ein Stromkreis vorgesehen ist, der während der Dauer des Intervalls zwischen der Impulsstrahlungszeit ($T_1$) und der nachfolgenden wiederholten Radarimpulsstrahlung ($I_r$) Bezugssignale erzeugt.

11. Anwendung nach einem der Ansprüche 8 bis 10, dadurch gekennzeichnet, wenigstens ein gespeichertes Signal ($V_M$) in einen wenigstens eine Schwelle aufweisenden Stromkreis eingegeben wird.

# FIG_1-a

Dispositif de commutation

# FIG_1-b

# FIG_2

**0 061 403**

FIG_3

FIG_4

FIG_5

(a)   (b)

2

## FIG_6

## FIG_7

## FIG_8

3

## FIG_9-a

## FIG_9-b

## FIG_10

4